# EUROPÄISCHE PATENTSCHRIFT

(11) **EP 3 381 043 B1**
(45) Veröffentlichungstag und Bekanntmachung des Hinweises auf die Patenterteilung: **28.07.2021**
(21) Anmeldenummer: 16801476.9
(22) Anmeldetag: 25.11.2016
(51) Int. Cl.: H01H 47/00, H01H 47/32, H02P 29/024, H02P 3/18, H02J 9/06, H01H 9/54

(54) **SCHALTGERÄT UND VERFAHREN ZUM ANSTEUERN EINER SCHALTEINRICHTUNG**
SWITCHING APPARATUS AND METHOD FOR ACTUATING A SWITCHING DEVICE
DISPOSITIF DE COMMUTATION ET PROCÉDÉ DE COMMANDE D'UN MOYEN DE COMMUTATION

(30) Priorität: 27.11.2015 DE 102015120670
(43) Veröffentlichungstag der Anmeldung: 03.10.2018
(73) Patentinhaber: Phoenix Contact GmbH & Co KG, 32825 Blomberg (DE)
(72) Erfinder: SCHAPER, Elmar, 32676 Lügde (DE); SCHULZ, Bernd, 37671 Höxter (DE); HEUER, Lutz, 32825 Blomberg (DE); HANSMEIER, Stephan, 32108 Bad Salzuflen (DE); PLEWKA, Dirk, 33039 Nieheim (DE); GÜNTER, Alexander, 32683 Barntrup (DE)
(74) Vertreter: Blumbach · Zinngrebe Patentanwälte PartG mbB
(86) Internationale Anmeldenummer: PCT/EP2016/078825
(87) Internationale Veröffentlichungsnummer: WO 2017/089548

(56) Entgegenhaltungen:
- EP-A2- 2 546 852
- WO-A1-2014/032718
- DE-A1- 10 309 937

## Beschreibung

Die Erfindung betrifft ein Schaltgerät zum Ansteuern einer Schalteinrichtung, insbesondere zum Ein- und Ausschalten einer elektrischen Last wie zum Beispiel eines Elektromotors, sowie ein entsprechendes Verfahren zum Ansteuern einer Schalteinrichtung.

Schaltgeräte zum Ansteuern von Schalteinrichtungen werden beispielsweise in der Automatisierungstechnik eingesetzt, insbesondere zum Ein- und Ausschalten elektrischer Lasten wie zum Beispiel Elektromotoren. Als Schalteinrichtungen kommen dabei insbesondere elektromechanische Schalter und/oder Halbleiterschalter zum Einsatz.

Elektromechanische Schalter wie beispielsweise Relais haben den Vorteil, dass diese einen geringen Innenwiderstand aufweisen und daher verlustarm sind. Allerdings treten beim Schalten Lichtbögen auf, wodurch die Kontakte auf Dauer beschädigt werden. Halbleiterschalter, wie zum Beispiel Thyristoren oder Triacs, erlauben hingegen ein im Wesentlichen verschleißfreies Schalten, jedoch haben diese einen höheren Innenwiderstand und erzeugen dadurch Verlustwärme, die aufwändig abgeführt werden muss. Bei sogenannten Hybridschaltern sind ein elektromechanischer Schalter und ein Halbleiterschalter parallel geschaltet, wobei der Halbleiterschalter den Strom während des Schaltvorganges übernimmt, so dass der elektromechanische Schalter im stromlosen Zustand geschaltet werden kann. Hybridschalter kombinieren somit die verschleißarme Halbleitertechnik und die verlustarme Relaistechnik, wobei die Ansteuerung der Schalter typischerweise mit einem Schaltgerät erfolgt, welches zu Steuerungszwecken einen Mikroprozessor umfasst.

Aber auch bei Einsatz von Hybridschaltern, beispielsweise in Motorschaltern, gibt es das Problem, dass es bei Ausfall der Versorgungsspannung zu einem unkontrollierten Abschalten der Ausgangsstufe und damit zu einem Öffnen der mechanischen Kontakte kommt, wobei es durch das unkontrollierte Abschalten insbesondere bei den mechanischen Kontakten zu einem erheblichen Verschleiß kommt. Unabhängig von der Dimensionierung der Kontakte führt dies zu einer Begrenzung der Lebensdauer.

Die Thyristoren oder Triacs eines Hybridschalters schalten im Stromnulldurchgang den Strom ab und ermöglichen es daher, den Stromfluss praktisch verschleißfrei zu unterbrechen. Dazu ist es jedoch erforderlich, die mechanischen Kontakte, zum Beispiel in einem Relais, solange in Position zu halten, bis der Abschaltvorgang abgeschlossen ist. Daher ist es bekannt, einen Energiepuffer in Schaltgeräten zu verwenden, um die Relais für diese Zeit noch versorgen zu können.

So wird beispielsweise in der WO 2014/032718 A1 ein Schaltgerät zum Steuern der Energiezufuhr eines nachgeschalteten Elektromotors beschrieben. Das Schaltgerät weist einen Versorgungsanschluss auf, an den über einen Not-Aus-Schalter eine Versorgungsquelle angeschlossen werden kann, welche zum Beispiel eine Versorgungsspannung von 24 Volt liefert. Weiterhin weist das bekannte Schaltgerät Anschlüsse zum Anschalten eines Versorgungsnetzes auf. Weitere Anschlüsse sind vorgesehen, um einen Elektromotor anschalten zu können. Um den Elektromotor an das Versorgungsnetz anschalten oder vom Versorgungsnetz trennen zu können, sind mehrere elektromechanische Schalter und Halbleiterschalter vorgesehen. Weiterhin ist im Schaltgerät eine Steuereinheit implementiert, die mittels der über den Versorgungsanschluss bezogenen elektrischen Energie die erforderlichen Schaltsignale, d.h. die erforderliche Erregerenergie an die jeweiligen Schalter ausgeben kann. Ferner weist das Schaltgerät einen Energiespeicher auf, der, wenn die Versorgungsspannung am Versorgungsanschluss in einen kritischen Bereich fällt, elektrische Energie der Steuereinheit zuführen kann, damit die Steuereinheit die erforderlichen Schaltsignale für die jeweiligen Schalter bereitstellen kann. Mit anderen Worten wird der Steuereinheit über den Versorgungsanschluss oder mittels des Energiespeichers die Energiemenge zugeführt, die sie benötigt, um einen elektromechanischen Schalter zu schließen oder geschlossen zu halten und einen Halbleiterschalter im leitenden Zustand halten zu können.

Ein ähnliches Schaltgerät ist aus der WO 2014/075742 A1 bekannt, bei welchem bei Unterschreiten eines ersten Spannungsschwellwertes eine automatische gesteuerte Abschaltung des Elektromotors erfolgt, wobei im Fall der Abschaltung die Zeit vom Unterschreiten des ersten Spannungsschwellwertes bis zum Unterschreiten eines zweiten Spannungsschwellwertes gemessen wird und die Steuereinheit ein Signal ausgibt, wenn diese Zeit einen kritischen Zeitwert unterschreitet. Auf diese Weise kann bei Durchführen einer automatischen Abschaltung des Elektromotors der Verschleiß des Energiespeichers ermittelt werden. Mittels des Signals kann ein Gerätefehler generiert werden, wodurch ein Wiedereinschalten des Schaltgerätes verhindert werden kann, so dass ein Verschleiß an den Schaltkontakten durch unkontrolliertes Abschalten vermieden werden kann, nachdem der Verschleiß des Energiespeichers erkannt worden ist. Wird jedoch für längere Zeit keine automatische Abschaltung durchgeführt, so kann es dennoch zu einem unkontrollierten Abschalten kommen, wenn zwischenzeitlich ein Verschleiß des Energiespeichers eingetreten ist, so dass die Energie des Energiespeichers nicht mehr zum Durchführen eines gesteuerten Abschaltvorgangs ausreicht.

Aus EP 2 546 852 A2 ist eine Schaltvorrichtung bekannt, die ein bistabiles Relais, eine Steuerungseinrichtung, einen Energiespeicher sowie eine Testeinrichtung umfasst, wobei die Steuerungseinrichtung zum Ansteuern des Relais ausgebildet ist, der Energiespeicher zum Bereitstellen einer Energie für wenigstens einen Zustandswechsel des Relais dient, und die Testeinrichtung zum Testen der Funktionsfähigkeit des Energiespeichers ausgebildet ist, und wobei die Steuerungseinrichtung und die Testeinrichtung gemeinsam den Energiespeicher zyklisch in einem Testverfahren testen können und feststellen können, ob der gespeicherte Energieinhalt zum sicheren Zurücksetzen des bistabilen Relais ausreichend ist. Der Energiespeicher kann insbesondere einen Kondensator umfassen, wobei die Kapazität des Kondensators ermittelt und mit einem Sollwert verglichen werden kann, um auf einen Fehler in dem Kondensator schließen zu können.

In DE 103 09 937 A1 wird eine Diagnoseschaltung zur Prüfung eines in einem Fahrzeug als Energiespeicher verwendeten Kondensators beschrieben, die ein Messmittel zur Erfassung der Kondensatorspannung, ein Messmittel zur Erfassung des Kondensatorstroms und ein Auswertemittel für die sich aufladungs- und entladungsbedingt ändernden Messwerte zur Bestimmung des Zustands des Kondensators aufweist, wobei insbesondere bei der Diagnoseschaltung vorgesehen ist, dass zur Bestimmung des Kondensatorzustands ein parallel zu dem Kondensator geschalteter, einen Stromsprung und einen Spannungseinbruch verursachender Test- oder Nutzverbraucher einschaltbar ist.

Der vorliegenden Erfindung liegt die Aufgabe zu Grunde, einen Weg aufzuzeigen, wie ein Schaltgerät zum Ansteuern einer Schalteinrichtung verbessert werden kann und ein entsprechend verbessertes Verfahren zum Ansteuern einer Schalteinrichtung anzugeben.

Diese Aufgabe wird durch die Merkmale der unabhängigen Ansprüche gelöst. Vorteilhafte Ausführungsformen sind Gegenstand der abhängigen Ansprüche.

Dementsprechend umfasst ein Schaltgerät zum Ansteuern wenigstens einer Schalteinrichtung eine Steuereinheit, die zum Ansteuern der wenigstens einen Schalteinrichtung ausgebildet ist, einen Anschluss zum Anlegen einer Versorgungsspannung zur Energieversorgung der Steuereinheit, einen mit dem Anschluss zum Anlegen einer Versorgungsspannung verbindbaren Energiespeicher, wobei der Energiespeicher dazu ausgebildet ist, die Steuereinheit bei Absinken oder Ausbleiben der Versorgungsspannung mit einer Energie zu versorgen, welche ausreicht, die wenigstens eine Schalteinrichtung derart anzusteuern, dass die Schalteinrichtung einen vorgegebenen Schaltvorgang ausführt. Ferner weist das Schaltgerät Mittel zur Überwachung der Funktionsfähigkeit des Energiespeichers auf, wobei die Überwachung insbesondere kontinuierlich erfolgt, d.h. eine Überprüfung der Funktionsfähigkeit des Energiespeichers zu vorgegebenen Zeitpunkten erfolgt, wobei diese Zeitpunkte insbesondere derart gewählt sind, dass zwischen zwei Prüfzeitpunkten typischerweise kein Verschleiß des Energiespeichers eintreten kann, der dazu führen würde, dass die Steuereinheit die wenigstens eine Schalteinrichtung nicht mehr zum Ausführen des vorgegebenen Schaltvorgangs ansteuern kann.

Ein Verfahren zum Ansteuern wenigstens einer Schalteinrichtung mittels eines Schaltgerätes, insbesondere mittels eines Schaltgerätes wie oben beschrieben, umfasst das Anlegen einer Versorgungsspannung an das Schaltgerät zur Energieversorgung einer Steuereinheit des Schaltgerätes, wobei die wenigstens eine Schalteinrichtung durch die Steuereinheit angesteuert wird, und wobei bei Absinken oder Ausbleiben der Versorgungsspannung die Steuereinheit durch einen mit der Versorgungsspannung verbindbaren Energiespeicher mit einer Energie versorgt wird, welche ausreicht, die wenigstens eine Schalteinrichtung derart anzusteuern, dass die Schalteinrichtung einen vorgegebenen Schaltvorgang ausführt, und wobei das Verfahren ein Überwachen der Funktionsfähigkeit des Energiespeichers umfasst, wobei das Überwachen insbesondere kontinuierlich erfolgt.

Ein Kerngedanke der Erfindung kann somit darin gesehen werden, eine kontinuierliche Überwachung eines zum Speichern elektrischer Energie eingesetzten Energiespeichers eines Schaltgerätes durchzuführen, so dass ein durch Verschleiß des Energiespeichers verursachtes unkontrolliertes Abschalten, insbesondere ein unkontrolliertes Öffnen eines elektromechanischen Schalters, sicher vermieden wird.

Als weitere bevorzugte Maßnahme zur Verbesserung eines Schaltgerätes kann ferner vorteilhaft vorgesehen sein, das Schaltgerät von weiteren Geräten, welche an die gleiche Versorgungsspannung angeschlossen sind, zu entkoppeln, um ein Abfließen von Energie des Energiespeichers hin zu diesen weiteren Geräten zu vermeiden.

Gemäß einer weiteren bevorzugten Maßnahme zur Verbesserung eines Schaltgerätes kann vorteilhaft vorgesehen sein, zum Ansteuern der Schalteinrichtung durch das Schaltgerät ein pulsweitenmoduliertes Signal zu verwenden, dessen Aussteuergrad in Abhängigkeit vorgegebener Parameter gesteuert wird, um eine Effizienzsteigerung zu erzielen und um eine möglichst kleine Dimensionierung des Energiespeichers zu ermöglichen.

Das Verfahren sieht vorteilhaft vor, zu vorgegebenen Zeitpunkten, insbesondere zyklisch, den Energiespeicher für eine vorgegebene Zeitdauer von der

Versorgungseinrichtung zu trennen, wobei die vorgegebene Zeitdauer so gewählt ist, dass während der vorgegebenen Zeitdauer im funktionsfähigen Zustand des Energiespeichers die im Energiespeicher gespeicherte Energie die zur Ausführung des vorgegebenen Schaltvorgangs erforderliche Energie nicht unterschreitet, wobei ferner vorteilhaft vorgesehen ist, dass eine dem Energiespeicher zugeordnete Messgröße, welche ein Maß für die im Energiespeicher gespeicherte Energie ist, gemessen wird, der Messwert mit einem vorgegebenen Schwellwert verglichen wird, und in Abhängigkeit des Vergleichergebnisses die Funktionsfähigkeit des Energiespeichers ermittelt wird.

Vorzugsweise wird bei Erkennen einer um ein vorgegebenes Maß reduzierten Funktionsfähigkeit des Energiespeichers die wenigstens eine Schalteinrichtung derart angesteuert, dass die Schalteinrichtung den vorgegebenen Schaltvorgang ausführt, sowie alternativ oder zusätzlich eine Fehlermeldung erzeugt.

Der vorgegebene Schaltvorgang umfasst insbesondere eine Schaltsequenz zur sicheren Abschaltung einer über die wenigstens eine Schalteinrichtung geschalteten elektrischen Last.

In einer vorteilhaften Ausgestaltung des Verfahrens ist ferner vorgesehen, dass das Schaltgerät von weiteren Geräten, insbesondere weiteren Schaltgeräten, die an die gleiche Versorgungsspannung angeschlossen sind, derart entkoppelt wird, dass ein Abfließen von in dem Energiespeicher gespeicherter Energie zu den weiteren Geräten verhindert wird.

Vorteilhaft steuert die Steuereinheit die wenigstens eine Schalteinrichtung mit einem pulsweitenmodulierten Schaltsignal an, wobei der Aussteuergrad des pulsweitenmodulierten Schaltsignals von der Steuereinheit in Abhängigkeit des Schaltzustands der Schalteinrichtung und/oder in Abhängigkeit der Versorgungsspannung und/oder in Abhängigkeit einer Umgebungstemperatur der Schalteinrichtung gesteuert wird. Vorzugsweise wird die Versorgungsspannung mittels einer mit der Steuereinheit verbundenen Spannungsmesseinrichtung überwacht.

Die Erfindung wird nachfolgend anhand einiger Ausführungsbeispiele in Verbindung mit den Zeichnungen näher erläutert. Gleiche Bezugszeichen bezeichnen dabei gleiche oder ähnliche Komponenten. Es zeigen:
- Fig. 1: schematisch eine bevorzugte Ausführungsform eines erfindungsgemäßen Schaltgeräts,
- Fig. 2: schematisch mehrere, an eine gemeinsame Not-Aus-Kette angeschlossene Schaltgeräte,
- Fig. 3: schematisch einen beispielhaften Verlauf der zur Versorgung der Steuereinheit des Schaltgerätes zur Verfügung stehenden Spannung mit und ohne einer zur Entkopplung eingesetzten Diode, sowie den davon abhängigen Beginn einer Abschaltsequenz,
- Fig. 4: schematisch und beispielhaft einen Spannungsverlauf am Energiespeicher eines Schaltgeräts bei einer zur Überwachung regelmäßig durchgeführten Funktionsprüfung des Energiespeichers, die entsprechende Schalterstellung des zum Trennen des Energiespeichers von der Versorgungsspannung eingesetzten Schalters, sowie den Motorbetrieb bei funktionsfähigem und defektem Energiespeicher.

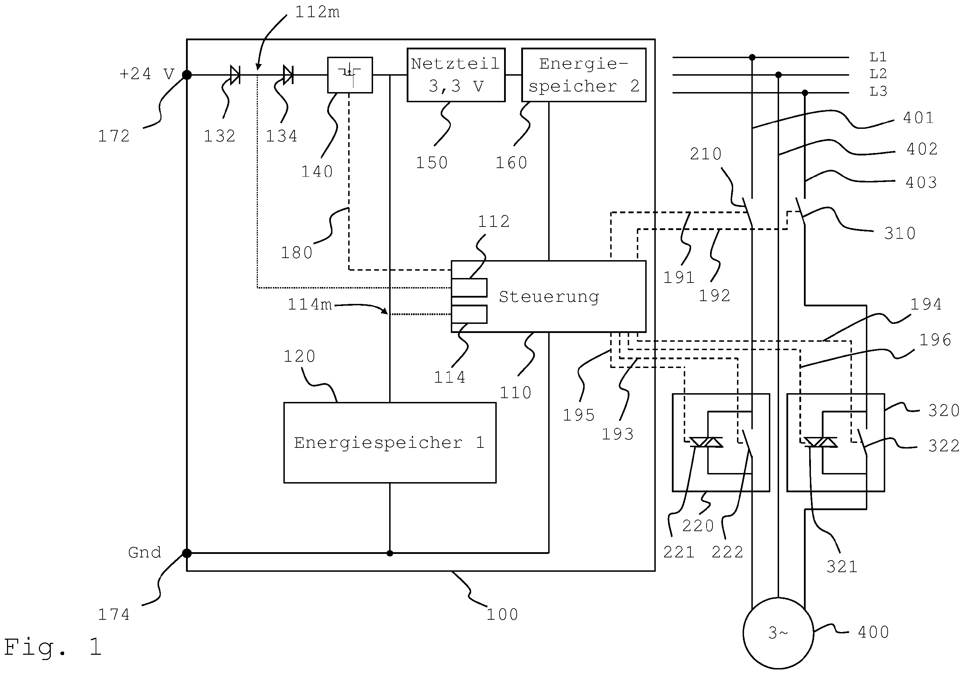

Fig. 1 zeigt ein beispielhaftes Schaltgerät 100 zum Ansteuern wenigstens einer Schalteinrichtung, wobei die wenigstens eine Schalteinrichtung im vorliegenden Beispiel die Schalteinrichtungen 210, 221, 222, 310, 321 und 322 umfasst, die zum Ein- und Ausschalten einer elektrischen Last 400 dienen, wobei die Last im dargestellten Beispiel als Drehstrommotor ausgebildet ist. Es sei angemerkt, dass die wenigstens eine Schalteinrichtung vorteilhaft auch im Schaltgerät 100 integriert sein kann.

Der Drehstrommotor 400 ist an ein Versorgungsnetz angeschlossen, welches im dargestellten Beispiel ein dreiphasiges Niederspannungsnetz mit den drei Leitern L1, L2, und L3 ist. Der Drehstrommotor 400 ist an die Leiter jeweils über Strompfade 401, 402 und 403 angeschlossen.

Zum Ein- und Ausschalten des Drehstrommotors 400 sind in den Strompfad 401 eine Reihenschaltung eines elektromechanischen Schalters 210 und eines Hybridschalters 220 geschaltet, wobei der Hybridschalter 220 aus einer Parallelschaltung eines Halbleiterschalters 221 und eines elektromechanischen Schalters 222 aufgebaut ist, und in den Strompfad 403 ist in analoger Weise eine Reihenschaltung eines elektromechanischen Schalters 310 und eines Hybridschalters 320 geschaltet, wobei der Hybridschalter 320 aus einer Parallelschaltung eines Halbleiterschalters 321 und eines elektromechanischen Schalters 322 aufgebaut ist. Die elektromechanischen Schalter 210, 222, 310 und 321 sind beispielsweise als Relais ausgebildet und die Halbleiterschalter 221 und 322 sind beispielsweise als Triacs ausgebildet.

Die Schalteinrichtungen 210, 221, 222, 310, 321 und 322 werden von der Steuereinheit 110 des Schaltgerätes 100 angesteuert. In Fig. 1 ist die Ansteuerung durch gestrichelte Linien 191 bis 196 angedeutet. Die Ansteuerung der Schalteinrichtungen 210, 221, 222, 310, 321 und 322 erfolgt typischerweise mittels entsprechender, in Fig. 1 nicht dargestellter Steuerstromkreise. Zum Ausführen der Steuerfunktionen weist die Steuereinheit 110 vorzugsweise einen Mikroprozessor auf. Ferner kann das Schaltgerät 100 mit einer übergeordneten Schalteinrichtung verbunden sein und von dieser Schaltbefehle zum Ein- oder Ausschalten des Drehstrommotors 400 empfangen.

Das Schaltgerät 100 ist an eine Versorgungsspannung angeschlossen, welche im dargestellten Beispiel an einem Versorgungsspannungsanschluss des Schaltgeräts 100, bestehend aus den Anschlussklemmen 172 und 174, eine Gleichspannung von 24 V bereitstellt, wobei die Anschlussklemme 174 mit Masse verbunden ist. Die Versorgungsspannung kann beispielsweise über ein externes, in Fig. 1 nicht dargestelltes Netzteil bereitgestellt werden.

Die Versorgungsspannung dient der Versorgung der Steuereinheit 110. Um auch bei Absinken oder Ausbleiben der Versorgungsspannung ein Ansteuern der Schalteinrichtungen derart zu gewährleisten, dass ein vorgegebener Schaltvorgang ausgeführt wird, ist ein mit dem Versorgungsspannungsanschluss verbindbarer erster Energiespeicher 120 vorgesehen, der die Steuereinheit 110 bei Absinken oder Ausbleiben der Versorgungsspannung noch für eine gewisse Zeit mit Energie versorgt.

Um die Funktionsfähigkeit des Energiespeichers kontinuierlich zu überwachen, weist das Schaltgerät 100 Mittel zur Überwachung der Funktionsfähigkeit des Energiespeichers 120 auf. Im dargestellten Beispiel umfassen diese einen von der Steuereinheit 110 steuerbaren Schalter 140. Die Ansteuerung des Schalters 140 ist durch die gestrichelte Linie 180 angedeutet.

Über ein durch die Steuereinheit 110 gesteuertes Öffnen des Schalters 140 wird der Energiespeicher 120 zu vorgegebenen Zeitpunkten für eine vorgegebene Zeitdauer von der Spannungsversorgung getrennt und es wird die Spannung am Energiespeicher 120 gemessen. Zu diesem Zweck weist die Steuereinheit 110 eine Spannungsmesseinrichtung 114 auf, welche die Spannung am Messpunkt 114m während der vorgegebenen Zeitdauer misst, wobei mittels einer A/D-Wandlung digitale Messwerte zur Verfügung gestellt werden können, die vom Mikroprozessor der Steuereinheit 120 verarbeitbar sind. Die am Energiespeicher 120 gemessene Spannung wird mit wenigstens einem vorgegebenen und vorzugsweise in der Steuereinheit 110 gespeicherten Referenz- oder Schwellwert verglichen.

Die Ausschaltzeit, d.h. die vorgegebene Zeitdauer, für welche der Energiespeicher 120 von der Spannungsversorgung getrennt wird, kann vorzugsweise sehr kurz gewählt werden, so dass das Trennen des Energiespeichers 120 keine Auswirkung auf die Funktion der Steuereinheit 110 hat. Die Zeitdauer kann beispielsweise etwa 100 ms betragen. Es kann aber auch eine andere geeignete Zeitdauer gewählt werden, die beispielsweise um wenigstens oder höchstens einen Faktor von 2, 5, 10, 20 oder 100 höher oder niedriger liegt. Zu diesem Zweck ist im dargestellten Beispiel ferner vorgesehen, dass die Steuereinheit 110 über ein eigenes internes Netzteil 150 mit eigenem, d.h. einem zweiten Energiespeicher 160 versorgt wird, wobei im dargstellten Beispiel das Netzteil 150 eine Spannung von 3,3 V bereitstellt.

Im dargstellten Beispiel sind die Energiespeicher 120 und 160 als Kondensatoren ausgebildet. Setzt ein Verschleiß bzw. ein Altern des Kondensators 120 ein, verringert sich die Kapazität des Kondensators 120 und damit seine Fähigkeit zur Speicherung elektrischer Energie bzw. seine Funktionsfähigkeit. Durch die Messung der Spannung am Energiespeicher 120 wird eine Reduzierung der Funktionsfähigkeit des Energiespeichers 120 erkannt, da die Spannung bei einer reduzierten Funktionsfähigkeit nach Trennen des Energiespeichers 120 von der Spannungsversorgung schneller absinkt als im voll funktionsfähigen Zustand.

Es sei angemerkt, dass das Überwachen der Funktionsfähigkeit des Energiespeichers vorzugsweise nur dann durchgeführt wird, wenn der Drehstrommotor 400 in Betrieb ist, d.h. wenn die Steuereinheit 110 Energie zum Ansteuern der Schalteinrichtungen 210, 221, 222, 310, 321 und 322 verbraucht.

Wird nach Trennen des Energiespeichers 120 von der Spannungsversorgung ein erster vorgegebener Schwellwert bzw. Pegel unterschritten, so bleibt der Drehstrommotor 400 zunächst in Betrieb. Das Erkennen eines Unterschreitens des ersten vorgegebenen Schwellwertes dient vorteilhaft dazu, zu erkennen, ob der Mechanismus der Funktionsprüfung, d.h. das Trennen des Energiespeichers 120 von der Spannungsversorgung durch Ansteuern des Schalters 140 korrekt funktioniert.

Eine Reduzierung der Funktionsfähigkeit des Energiespeichers 120 um ein vorgegebenes Maß wird dadurch erkannt, dass die am Energiespeicher 120 gemessene Spannung einen zweiten Schwellwert oder Pegel unterschreitet. Sobald das Unterschreiten dieses zweiten Schwellwertes erkannt wird, findet eine Abschaltung des Drehstrommotors statt.

Das vorgegebene Maß der Reduzierung der Funktionsfähigkeit des Energiespeichers 120 und damit der zweite Schwellwert werden vorzugsweise derart gewählt, dass bei Unterschreiten des zweiten Schwellwertes der Energiespeicher 120 die Steuereinheit noch mit einer Energie versorgen kann, welche ausreicht, die Schalteinrichtungen 210, 221, 222, 310, 321 und 322 derart anzusteuern, dass ein vorgegebener Schaltvorgang ausgeführt wird. Der vorgegebene Schaltvorgang umfasst dabei insbesondere eine ordnungsgemäße sequentielle Abschaltung des Drehstrommotors 400, bei welcher insbesondere ein Verschleiß der elektromechanischen Schalter 210, 222, 310 und 322 verhindert wird.

Die Spannungsmessung am Energiespeicher 120 liefert einen Wert, der die noch im Energiespeicher 120 befindliche Energie repräsentiert. Die bei Einleiten der Abschaltsequenz noch zur Verfügung stehende Energie kann vorteilhaft auch dazu genutzt werden, den Gerätestatus des Schaltgerätes 100, beispielsweise umfassend Diagnosedaten bezüglich des Schaltgerätes 100 und einer durch die Steuereinheit 110 ausgeführten Applikation, in einem Gerätespeicher des Schaltgerätes 100 abzulegen. Alternativ oder zusätzlich könnte auch eine Rückmeldung vom Schaltgerät 100 an eine mit dem Schaltgerät 100 verbundene übergeordnete Steuereinrichtung erfolgen. Ferner könnte am Schaltgerät 100 oder mittels der in Fig. 1 nicht dargestellten übergeordneten Steuereinrichtung eine Fehlermeldung ausgegeben werden, welche beispielhaft folgendermaßen lauten könnte: "Achtung interner Fehler, Abschaltung erfolgt über Relais".

Zur Messung der Versorgungsspannung weist die Steuereinheit 110 eine Spannungsmesseinrichtung 112 auf, welche die Spannung am Messpunkt 112m misst, wobei mittels einer A/D-Wandlung digitale Messwerte zur Verfügung gestellt werden können, die vom Mikroprozessor der Steuereinheit 120 verarbeitet werden können. Die Spannungsmesseinrichtung 112 kann aber im Wesentlichen auch nur eine digitale Information liefern, ob die Versorgung des Gerätes noch aktiv ist, um so noch maximal viel Zeit für das Durchführen der Abschaltsequenz zu haben. Daher könnte die Spannungsmesseinrichtung 112 alternativ auch als Digitaleingang realisiert werden.

Das Messen der Versorgungsspannung dient insbesondere auch dazu, während der oben beschriebenen Funktionsprüfung zu erkennen, ob die Versorgungsspannung während der vorgegebenen Zeitdauer, während der der Energiespeicher 120 durch Öffnen des Schalters 140 von der Versorgungsspannung getrennt wird, absinkt oder abgeschaltet wird, um zu erkennen, ob das Unterschreiten des zweiten Schwellwertes aufgrund einer reduzierten Funktionsfähigkeit des Energiespeichers 120 oder aufgrund eines Absinkens oder Ausbleibens der Versorgungsspannung erfolgt.

Um die Spannung am Energiespeicher 120 unabhängig von der angelegten Versorgungsspannung messen zu können, ist zur Entkopplung eine Diode 134 vorgesehen.

Allgemein umfasst das Schaltgerät 100 zur Überwachung der Funktionsfähigkeit des Energiespeichers 120 vorzugsweise wenigstens eine mit der Steuereinheit 110 verbundene Messeinrichtung 114 zum Messen einer dem Energiespeicher 120 zugeordneten Messgröße, welche ein Maß für die im Energiespeicher 120 gespeicherte Energie ist, und ein von der Steuereinheit 110 steuerbares Mittel 140 zum Trennen des Energiespeichers 120 von der Versorgungsspannung, wobei die Steuereinheit 110 dazu ausgebildet ist, den Energiespeicher 120 zu vorgegebenen Zeitpunkten für eine vorgegebene Zeitdauer von der Versorgungsspannung zu trennen, die dem Energiespeicher 120 zugeordnete Messgröße zu messen und den Messwert mit einem vorgegebenen Schwellwert zu vergleichen, wobei die Steuereinheit 110 ferner dazu ausgebildet ist, die Funktionsfähigkeit des Energiespeichers 120 in Abhängigkeit des Vergleichergebnisses zu ermitteln, und wobei der Energiespeicher 120 so dimensioniert ist, dass im funktionsfähigen Zustand des Energiespeichers 120 die im Energiespeicher 120 gespeicherte Energie während der vorgegebenen Zeitdauer die zur Ausführung des vorgegebenen Schaltvorgangs erforderliche Energie nicht unterschreitet.

Wie bereits oben erwähnt umfasst der vorgegebene Schaltvorgang vorzugsweise eine Schaltsequenz zur sicheren Abschaltung der über die wenigstens eine Schalteinrichtung 210, 221, 222, 310, 321 und 322 geschalteten elektrischen Last 400.

Es sei angemerkt, dass bei eingeschaltetem Drehstrommotor 400 die elektromechanischen Schalter 210 und 310, sowie 222 und 322 geschlossen sind und durch einen von der Steuereinheit 110 bereitgestellten Haltestrom in diesem Schaltzustand gehalten werden, und dass die Halbleiterschalter 221 und 321 abgeschaltet sind.

In der Schaltsequenz, im Folgenden auch Abschaltsequenz, werden zunächst die Halbleiterschalter 221 und 321 eingeschaltet und die elektromechanischen Schalter 222 und 322 ohne Last geöffnet. Dann werden die Halbleiterschalter 221 und 321 abgeschaltet und somit die Stromversorgung des Drehstrommotors 400 unterbrochen und danach werden die elektromechanischen Schalter 210 und 310 ohne Last geöffnet.

Das Einschalten der elektrischen Last 400 erfolgt durch eine Schaltsequenz mit umgekehrter Reihenfolge, d.h. es werden die elektromechanischen Schalter 210 und 310 geschlossen, die Halbleiterschalter 221 und 321 werden eingeschaltet, nach dem Einschalten der Halbleiterschalter 221 und 321 werden die elektromechanischen Schalter 222 und 322 geschlossen und übernehmen als Bypass den Stromfluss von den Halbleiterschaltern 221 und 321, welche nach Schließen der elektromechanischen Schalter 222 und 322 abgeschaltet werden. Wie bereits oben erwähnt, sind die elektromechanischen Schalter 210, 222, 310 und 322 vorzugsweise als Relais ausgebildet. Im eingeschalteten Zustand sind die Relaisspulen ständig angesteuert, wobei in dieser Halte-Phase nur noch ein geringerer Magnetisierungsstrom in den Relais benötigt wird als zum Anziehen der Relais erforderlich ist.

Um eine bessere Energieeffizienz zu gewährleisten, ist in einer bevorzugten Ausführung des Schaltgerätes 100 die Steuereinheit 110 dazu ausgebildet, wenigstens eine Schalteinrichtung mit einem pulsweitenmodulierten Schaltsignal anzusteuern. Besonders vorteilhaft wird ein pulsweitenmoduliertes Schaltsignal für die Ansteuerung von Relais wie den Schaltern 210, 222, 310 und 322 eingesetzt, es kann aber vorteilhaft auch für die Ansteuerung von Halbleiterschaltern wie den Triacs 221 und 321 ein pulsweitenmoduliertes Schaltsignal eingesetzt werden.

Ein pulsweitenmoduliertes Signal ist ein elektrisches Signal, welches während einer zeitlichen Periode zwischen wenigstens zwei Werten der Spannung und/oder des Stroms wechselt. Vorzugsweise handelt es sich bei einem pulsweitenmodulierten Signal um ein Rechtecksignal, wobei auch andere Signale im Rahmen der Erfindung liegen. Im Folgenden wird, wenn nicht anders angegebene, von einem Rechtecksignal ausgegangen. Ein pulsweitenmoduliertes Signal umfasst eine periodische Folge von Impulsen oder Pulsen, wobei der Aussteuergrad oder Tastgrad eines pulsweitenmodulierten Signals das Verhältnis der Impulsdauer oder Pulsweite zur Periodendauer angibt.

Da beispielsweise zum Ansteuern eines Relais abhängig von der jeweiligen Schaltsituation, d.h. abhängig davon, ob aktuell ein Anziehen des Relais oder ein ständiges Ansteuern des Relais erfolgt, unterschiedliche Magnetisierungsströme benötigt werden, wird der Aussteuergrad des pulsweitenmodulierten Schaltsignals von der Steuereinheit vorzugsweise in Abhängigkeit des Schaltzustands der Schalteinrichtung gesteuert, insbesondere in Abhängigkeit der jeweils zum Ansteuern erforderlichen elektrischen Energie.

Zum Ausgleichen von Schwankungen der Versorgungsspannung kann der Aussteuergrad des pulsweitenmodulierten Schaltsignals von der Steuereinheit ferner alternativ oder zusätzlich in Abhängigkeit der Versorgungsspannung gesteuert werden. Da die zum Ansteuern einer Schalteinrichtung erforderliche elektrische Energie typischerweise auch von der Umgebungstemperatur abhängt, kann alternativ oder zusätzlich der Aussteuergrad des pulsweitenmodulierten Schaltsignals von der Steuereinheit auch in Abhängigkeit einer Umgebungstemperatur der jeweiligen Schalteinrichtung gesteuert werden. Zum Beispiel ist der benötigte Zündstrom für Thyristoren und Triacs stark von der Temperatur der Halbleiter abhängig, wobei bei geringen Temperaturen ein höherer Zündstrom benötigt wird. Ein höherer Zündstrom führt jedoch bei hohen Temperaturen zu unnötigen Verlusten. Insbesondere kann der Aussteuergrad des pulsweitenmodulierten Schaltsignals vorteilhaft für jede durch die Steuereinheit 110 gesteuerte Schalteinrichtung individuell gesteuert werden.

Um die jeweiligen Parameter, wie Schaltzustand bzw. aktuell zum Ansteuern erforderliche elektrische Energie oder Umgebungstemperatur zu ermitteln, sind vorteilhaft entsprechende, in Fig. 1 nicht dargestellte, Messeinrichtungen vorgesehen.

Insbesondere wenn die 24V-Versorgungsspannung abgeschaltet wird und die Spannung am Energiespeicher 120 absinkt, wie dies für die oben beschriebene Überwachung der Funktionsfähigkeit des Energiespeichers 120 erfolgt, wird vorteilhaft der Aussteuergrad der pulsweitenmodulierten Schaltsignale nachgeführt, um insbesondere den erforderlichen Magnetisierungsstrom in den Relais möglichst lange aufrecht erhalten zu können. Auf diese Weise kann die zur Verfügung stehende gespeicherte Energie maximal ausgenutzt werden und der Energiespeicher 120 möglichst klein dimensioniert werden.

Fällt die Versorgungsspannung beispielsweise auf 15V ab, kann der Aussteuergrad der pulsweitenmodulierten Signale zum Beispiel auf etwa 50% eingestellt werden, und wenn die Versorgungsspannung auf 30V steigt, so kann der Aussteuergrad der pulsweitenmodulierten Schaltsignale auf etwa 25% abgesenkt werden. Durch die Nachführung der Pulsweitenmodulation ist es möglich, den Kondensator 120 auf etwa ein Viertel des sonst üblichen Wertes zu dimensionieren, der beispielsweise auf Basis von Worst-Case-Annahmen bestimmt würde.

Ein weiterer Nutzen ist die Energieeinsparung, die außerdem eine kleinere und damit günstigere Dimensionierung der Bauteile im geräteinternen Netzteil 150 zulässt. Durch den nachgeführten Aussteuergrad der pulsweitenmodulierten Schaltsignale wird immer nur so viel Energie aufgenommen, wie tatsächlich zum Betrieb der Relais in der jeweiligen Situation notwendig ist.

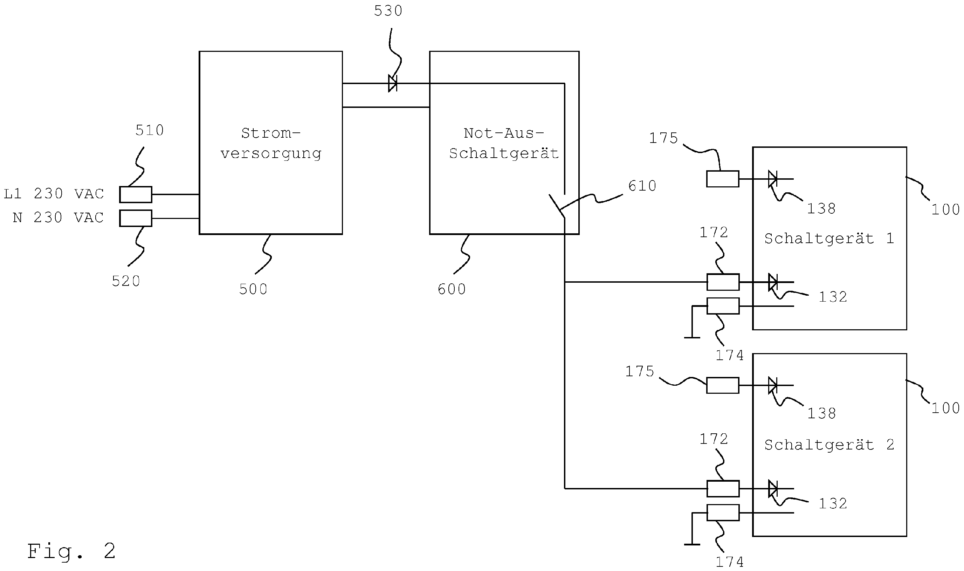

In Fig. 2 sind schematisch mehrere, an eine gemeinsame Not-Aus-Kette angeschlossene Schaltgeräte 100 dargestellt.

Im dargestellten Ausführungsbeispiel sind an die Stromversorgung 500, welche beispielsweise als 24 V-Netzteil ausgebildet sein kann, über ein Not-Aus-Schaltgerät 600 zwei Schaltgeräte 100 angeschlossen. Insbesondere ist ein Strompfad von der Stromversorgung zu den Anschlussklemmen 172 der Schaltgeräte 100 vorgesehen, welcher durch Öffnen des Not-Aus-Schalters 610 des Not-Aus-Schaltgerätes 600 unterbrochen werden kann. Die Anschlussklemmen 174 der Schaltgeräte 100 sind mit Masse verbunden. Im dargestellten Ausführungsbeispiel ist das Netzteil 500 über die Anschlussklemmen 510 und 520 an ein einphasiges Niederspannungsnetz angeschlossen, welches durch einen L1- und einen N-Leiter des in Fig. 1 dargestellten dreiphasigen Niederspannungsnetzes bereitgestellt sein kann. Die in Fig. 2 dargestellte Diode 530 dient beispielsweise einem Verpolschutz.

In der Praxis ist es oft üblich, mehr als ein Gerät an die Geräteversorgung 500 bzw. an die Not-Aus-Kette zu legen, wobei dies auch eine Mehrzahl, auch unterschiedlicher Geräte umfassen kann. Lediglich der einfacheren Darstellung halber sind in Fig. 2 nur zwei beispielhafte Schaltgeräte 100 dargestellt.

Wie im Zusammenhang mit Fig. 1 beschrieben, weisen die Schaltgeräte 100 im Eingangskreis der Geräteversorgung einen Energiespeicher 120 auf, der bei Ausfall der Geräteversorgung die notwendige Energie für ein sequentielles Abschalten zur Verfügung stellt. Daher ist besonders vorteilhaft vorgesehen, dass durch eine Entkopplung am Geräteeingang ein Energierückfluss zu anderen Geräten verhindert wird. Dies wird in dem in Fig. 2 dargestellten Beispiel durch die Dioden 132 erreicht.

In Fig. 2 sind ferner Anschlüsse 175 der Schaltgeräte 100 dargestellt, über welche die Schaltgeräte 100 mit einer nicht dargestellten übergeordneten Schalteinrichtung verbunden werden können, von der sie beispielsweise Schaltbefehle zum Ein- oder Ausschalten des Drehstrommotors 400 empfangen können. Zweckmäßigerweise sind auch mit diesen Anschlüssen 175 jeweils verbundene Dioden 138 vorgesehen.

Durch die Entkopplung mittels der Dioden 132 können auch Spannungsschwankungen oder Unterbrechungen an der 24V-Versorgung überbrückt werden. Ohne Entkopplung kann es zum schnelleren Entladen des Energiespeichers 120 und damit zu einer gegebenenfalls unkontrollierten Abschaltung kommen.

Durch die Entkopplung kann die Energie im Energiespeicher 120 solange genutzt werden, bis die Spannung am Energiespeicher auf einen kritischen Punkt abgesunken ist, insbesondere auf den oben beschriebenen zweiten Schwellwert, bei dessen Unterschreiten die Abschaltung des Drehstrommotors 400 eingeleitet wird.

Die Vorteile einer Entkopplung sind darin zu sehen, dass bei Ausfall der Versorgungsspannung ein sequentielles Abschalten der Ausgangsstufe gesichert ist, die Empfindlichkeit gegen Spannungsschwankungen reduziert wird, eine längere Verfügbarkeit bei Absinken der Versorgungsspannung gewährleistet wird, kurze Unterbrechungen der Versorgungsspannung überbrückt werden können, und die im Energiespeicher 120 zur Verfügung stehende Energie im vollen Umfang dem jeweiligen Schaltgerät 100 zur Verfügung steht.

Die Diode 132 zur Entkopplung zum Vermeiden eines Abfließens elektrischer Energie vom Energiespeicher 120 zu anderen Geräten, ist auch bei dem in Fig. 1 dargestellten Schaltgerät 100 vorgesehen. Die Funktion kann jedoch auch durch die Diode 134 erfüllt werden, so dass bei dem in Fig. 1 dargestellten Schaltgerät vorteilhaft auch auf die Diode 132 verzichtet werden könnte.

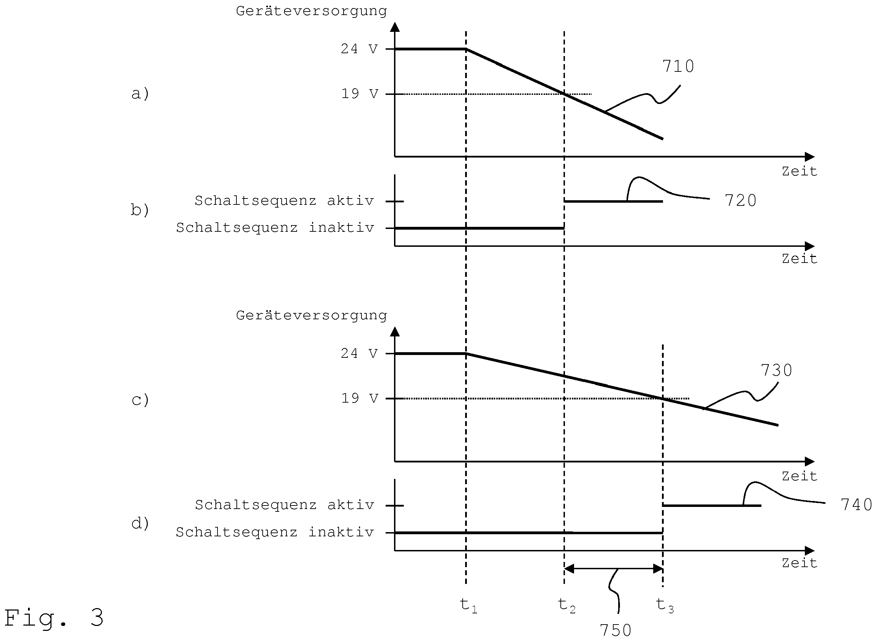

In Fig. 3 ist schematisch die Wirkung des Einsatzes einer Diode zur Entkopplung dargestellt.

In Fig. 3 a) und b) ist beispielhaft die Situation dargestellt, die ohne den Einsatz einer Diode zur Entkopplung von anderen Geräten vorliegen würde. Fig. 3 a) zeigt einen beispielhaften Spannungsverlauf 710 der Geräteversorgung, d.h. den Verlauf der Spannung am Energiespeicher 120. Im dargestellten Beispiel sinkt die Spannung ab dem Zeitpunkt t₁ stark ab, da beispielsweise die Spannung der Spannungsversorgung abgefallen ist und von anderen Geräten Energie aus dem Energiespeicher 120 abgezogen wird. Bei Unterschreiten des zweiten Schwellwertes, der im dargestellten Beispiel bei 19 V liegt, wird die Abschaltsequenz aktiviert, d.h. die Abschaltung des Drehstrommotors 400 eingeleitet. Dies ist in Fig. 3 b) schematisch durch den Verlauf 720 dargestellt, welcher angibt, ob die Schaltsequenz aktiv oder inaktiv ist.

In Fig. 3 c) und d) ist beispielhaft die Situation dargestellt, die mit Einsatz einer Diode zur Entkopplung von anderen Geräten vorliegt. Fig. 3 c) zeigt einen beispielhaften Spannungsverlauf 730 der Geräteversorgung, d.h. den Verlauf der Spannung am Energiespeicher 120. Im dargestellten Beispiel sinkt die Spannung ab dem Zeitpunkt t₁, zu dem beispielsweise die Spannung der Spannungsversorgung abgefallen ist, nicht dadurch ab, dass von anderen Geräten Energie aus dem Energiespeicher 120 abgezogen wird. Dadurch wird der Schwellwert von 19 V erst zum Zeitpunkt t₃ unterschritten und die Abschaltsequenz aktiviert, d.h. die Abschaltung des Drehstrommotors 400 eingeleitet. Dies ist in Fig. 3 d) schematisch durch den Verlauf 740 dargestellt.

Somit ergibt sich die durch Bezugszeichen 750 bezeichnete zusätzliche Verfügbarkeit, da die Abschaltung um die Differenz aus t₃ und t₂ verzögert erfolgt.

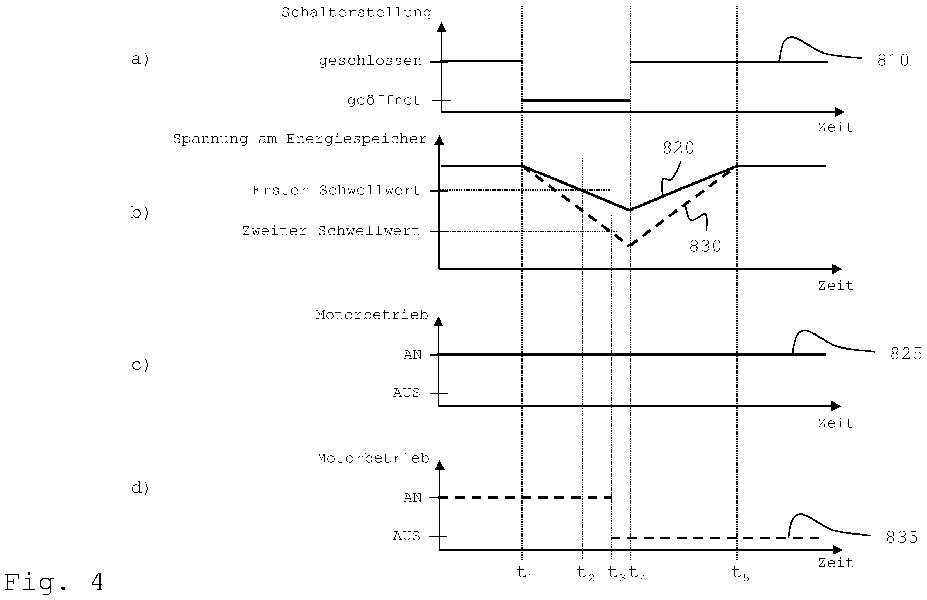

In Fig. 4 ist der Ablauf einer Funktionsprüfung des Energiespeichers 120 nochmals schematisch dargestellt. Der in Fig. 4 dargestellte Vorgang wird zur Überwachung der Funktionsfähigkeit des Energiespeichers 120 vorzugsweise zu vorgegebenen Zeitpunkten, insbesondere zyklisch, wiederholt.

In Fig. 4 a) ist der zeitliche Verlauf 810 der Schalterstellung des Schalters 140 dargestellt. Der Schalter 140 ist im normalen Betrieb zunächst geschlossen. Zur Funktionsprüfung des Energiespeichers 120 wird der Schalter 140 zum Zeitpunkt t₁, gesteuert durch die Steuereinheit 110, geöffnet und zum Zeitpunkt t₄ wieder geschlossen. Durch Öffnen des Schalters 140 wird der Energiespeicher 120 von der Spannungsversorgung getrennt und die Spannung am Energiespeicher 120 sinkt bis zum Zeitpunkt t₄ ab. Durch Schließen des Schalters wird der Energiespeicher 120 wieder mit der Spannungsversorgung verbunden und dementsprechend wieder aufgeladen, bis er zum Zeitpunkt t₅ wieder voll aufgeladen ist.

Der Spannungsverlauf am Energiespeicher 120 ist in Fig. 4 b) dargestellt, wobei der durchgezogene Verlauf 820 den Spannungsverlauf eines voll funktionsfähigen Energiespeichers 120 wiedergibt und der gestrichelte Verlauf 830 den Spannungsverlauf eines defekten Energiespeichers 120.

Ein erster Schwellwert wird auch bei Vorliegen eines voll funktionsfähigen Energiespeichers 120 unterschritten, im dargestellten Beispiel zum Zeitpunkt t₂, wobei dieser Schwellwert, wie oben beschrieben, dazu dient zu erkennen, ob der Mechanismus der Funktionsprüfung, d.h. das Trennen des Energiespeichers 120 von der Spannungsversorgung durch Ansteuern des Schalters 140 korrekt funktioniert.

Der zweite Schwellwert wird bei Vorliegen eines voll funktionsfähigen Energiespeichers 120 nicht unterschritten, bei Vorliegen eines defekten Energiespeichers 120 jedoch schon, und zwar im dargestellten Beispiel zum Zeitpunkt t₃.

Durch Unterschreiten des zweiten Schwellwertes wird eine Abschaltung des Motors 400 eingeleitet.

Die in Fig. 4 c) und d) jeweils dargestellten Verläufe 825 bzw. 835 geben den Motorbetrieb wieder, d.h. ob der Motor 400 eingeschaltet (AN) oder ausgeschaltet (AUS) ist, und zwar in Fig. 4 c) für einen voll funktionsfähigen Energiespeicher 120 und in Fig. 4 d) für einen defekten Energiespeicher 120.

Es sei angemerkt, dass der in Fig. 4 c) und d) jeweils dargestellte Motorbetriebszustand als logischer Zustand innerhalb der Steuerapplikation der Steuereinheit 110 anzusehen ist, und dass bei defektem Energiespeicher 120 zum Zeitpunkt t₃ die Abschaltsequenz eingeleitet wird, der Motor aber erst im Verlauf der Abschaltsequenz, und zwar mit Abschalten der Triacs 221 und 321 nach Öffnen der Schalter 222 und 322, wie oben beschrieben, von der Spannungsversorgung getrennt und damit tatsächlich abgeschaltet ist.

Es sei ferner angemerkt, dass die Funktionsprüfung in so kurzen Zeitabständen wiederholt wird, dass sichergestellt ist, dass auch bei Erkennen eines defekten Energiespeichers 120 dieser noch ausreichend funktionsfähig ist, um eine sichere Abschaltung zu gewährleisten. In einer vorteilhaften Ausführungsform kann beispielsweise eine Funktionsprüfung einmal täglich, d.h. in Zeitabständen von 24 Betriebsstunden, erfolgen. Es können aber auch andere geeignete Zeitabstände gewählt werden, die beispielsweise um wenigstens oder höchstens einen Faktor von 2, 5, 10, 20 oder 100 höher oder niedriger liegen.

Eine Überwachung, d.h. eine kontinuierliche Überprüfung, der Funktionsfähigkeit des Energiespeichers 120, wie die Erfindung sie vorschlägt, ist besonders vorteilhaft für Dauerläufer-Applikationen wie zum Beispiel Pumpen oder Lüfter. Da die Alterung sich üblicherweise als eine Reduzierung der Kapazität äußert, kann es so zum Ausfall des Energiespeichers kommen und keine sequentielle Abschaltung mehr stattfinden, so dass die Relais verschweißen können. Gerade durch Dauerbetrieb und bei hohen Temperaturen kann es zu einer schnellen Alterung des Energiespeicherkondensators kommen, wobei aus dem Stand der Technik bekannte Schaltgeräte eine solche Alterung insbesondere bei im Dauerbetrieb eingesetzten Geräten nicht erkennen.

### Bezugszeichenliste

- 100: Schaltgerät
- 110: Steuereinheit
- 112, 114: Spannungsmesseinrichtungen
- 112m, 114m: Messpunkte zur Spannungsmessung
- 120: erster Energiespeicher
- 132, 134: Dioden
- 138: Diode
- 140: steuerbarer Schalter
- 150: Netzteil 3,3 V
- 160: zweiter Energiespeicher
- 172, 174: Anschlussklemmen zum Anlegen einer Versorgungsspannung
- 175: Anschluss zum Ansteuern durch eine übergeordnete Steuereinrichtung
- 180: Verbindung zum Ansteuern des steuerbaren Schalters
- 191-194: Ansteuerung der elektromechanischen Schalter
- 195, 196: Ansteuerung der Triacs
- 210, 310: elektromechanische Schalter, insbesondere Relais
- 220, 320: Hybridschalter
- 221,321: Triacs
- 222, 322: elektromechanische Schalter, insbesondere Relais
- 400: elektrische Last, insbesondere Elektromotor
- 401-403: Strompfade
- 500: Energieversorgungsquelle, z.B. 24V-Netzteil
- 510, 520: Anschlüsse zum Anschließen an ein Versorgungsnetz
- 530: Diode
- 600: Not-Aus-Schaltgerät
- 610: Not-Aus-Schalter
- 710: Spannungsverlauf ohne Diode
- 720: Aktivitätsverlauf der Schaltsequenz ohne Diode
- 730: Spannungsverlauf mit Diode
- 740: Aktivitätsverlauf der Schaltsequenz mit Diode
- 750: Zeitdauer zusätzlicher Verfügbarkeit
- 810: Zeitlicher Verlauf der Schalterstellung
- 820: Spannungsverlauf am Energiespeicher bei funktionsfähigem Energiespeicher
- 825: Motorbetrieb bei funktionsfähigem Energiespeicher
- 830: Spannungsverlauf am Energiespeicher bei defektem Energiespeicher
- 835: Motorbetrieb bei defektem Energiespeicher

## Patentansprüche

1. Schaltgerät (100) zum Ansteuern wenigstens einer Schalteinrichtung (210, 221, 222, 310, 321, 322), umfassend
- eine Steuereinheit (110), die zum Ansteuern der wenigstens einen Schalteinrichtung (210, 221, 222, 310, 321, 322) ausgebildet ist,
- einen Anschluss (172, 174) zum Anlegen einer Versorgungsspannung zur Energieversorgung der Steuereinheit (110),
- einen mit dem Anschluss (172, 174) zum Anlegen einer Versorgungsspannung verbindbaren Energiespeicher (120), welcher dazu ausgebildet ist, die Steuereinheit (110) bei Absinken oder Ausbleiben der Versorgungsspannung mit einer Energie zu versorgen, welche ausreicht, die wenigstens eine Schalteinrichtung (210, 221, 222, 310, 321, 322) derart anzusteuern, dass die Schalteinrichtung (210, 221, 222, 310, 321, 322) einen vorgegebenen Schaltvorgang ausführt,
wobei das Schaltgerät (100) Mittel (112, 114, 134, 140) zur Überwachung der Funktionsfähigkeit des Energiespeichers (120) aufweist, **dadurch gekennzeichnet, dass** das Schaltgerät (100) wenigstens eine mit der Steuereinheit (100) verbundene Messeinrichtung (114) zum Messen einer dem Energiespeicher (120) zugeordneten Messgröße, welche ein Maß für die im Energiespeicher (120) gespeicherte Energie ist, und ein von der Steuereinheit (110) steuerbares Mittel (140) zum Trennen des Energiespeichers (120) von der Versorgungsspannung aufweist, wobei
die Steuereinheit (110) dazu ausgebildet ist, den Energiespeicher (120) zu vorgegebenen Zeitpunkten für eine vorgegebene Zeitdauer von der Versorgungsspannung zu trennen, die dem Energiespeicher (120) zugeordnete Messgröße zu messen und den Messwert mit einem vorgegebenen Schwellwert zu vergleichen, wobei die Steuereinheit (110) ferner dazu ausgebildet ist, die Funktionsfähigkeit des Energiespeichers (120) in Abhängigkeit des Vergleichsergebnisses zu ermitteln, und wobei der Energiespeicher (120) so dimensioniert ist, dass im funktionsfähigen Zustand des Energiespeichers (120) die im Energiespeicher (120) gespeicherte Energie während der vorgegebenen Zeitdauer die zur Ausführung des vorgegebenen Schaltvorgangs erforderliche Energie nicht unterschreitet.

2. Schaltgerät nach Anspruch 1, wobei der Energiespeicher als Kondensator (120) ausgebildet ist, die dem Energiespeicher zugeordnete Messgröße die vom Kondensator (120) bereitgestellte Spannung ist, und die Messeinrichtung zum Messen der dem Energiespeicher zugeordneten Messgröße als Spannungsmesseinrichtung (114) ausgebildet ist.

3. Schaltgerät nach einem der vorstehenden Ansprüche, dazu ausgebildet, bei Erkennen einer um ein vorgegebenes Maß reduzierten Funktionsfähigkeit des Energiespeichers (120) die wenigstens eine Schalteinrichtung (210, 221, 222, 310, 321, 322) derart anzusteuern, dass die Schalteinrichtung den vorgegebenen Schaltvorgang ausführt, und/oder eine Fehlermeldung zu erzeugen.

4. Schaltgerät nach einem der vorstehenden Ansprüche, wobei der vorgegebene Schaltvorgang eine Schaltsequenz zur sicheren Abschaltung einer über die wenigstens eine Schalteinrichtung (210, 221, 222, 310, 321, 322) geschalteten elektrischen Last (400) umfasst.

5. Schaltgerät nach einem der vorstehenden Ansprüche, umfassend eine Entkopplungseinrichtung (132, 134) zur Entkopplung des Schaltgerätes (100) von weiteren Geräten, insbesondere weiteren Schaltgeräten (100), die an die Versorgungsspannung angeschlossen sind, wobei die Entkopplungseinrichtung (132, 134) dazu ausgebildet ist, ein Abfließen von in dem Energiespeicher (120) gespeicherter Energie zu den weiteren Geräten zu verhindern, und wobei die Entkopplungseinrichtung insbesondere wenigstens eine Diode (132, 134) umfasst.

6. Schaltgerät nach einem der vorstehenden Ansprüche, wobei die Steuereinheit (110) dazu ausgebildet ist, die wenigstens eine Schalteinrichtung (210, 221, 222, 310, 321, 322) mit einem pulsweitenmodulierten Schaltsignal anzusteuern, wobei der Aussteuergrad des pulsweitenmodulierten Schaltsignals von der Steuereinheit (110) in Abhängigkeit des Schaltzustands der Schalteinrichtung (210, 221, 222, 310, 321, 322) und/oder in Abhängigkeit der Versorgungsspannung und/oder in Abhängigkeit einer Umgebungstemperatur der Schalteinrichtung (210, 221, 222, 310, 321, 322) gesteuert wird.

7. Schaltgerät nach einem der vorstehenden Ansprüche, umfassend eine mit der Steuereinheit (110) verbundene Spannungsmesseinrichtung (112) zum Überwachen der Versorgungsspannung.

8. Verfahren zum Ansteuern wenigstens einer Schalteinrichtung (210, 221, 222, 310, 321, 322) mittels eines Schaltgerätes (100) nach einem der Ansprüche 1 bis 7, mit den Schritten:
- Anlegen einer Versorgungsspannung an das Schaltgerät (100) zur Energieversorgung einer Steuereinheit (110) des Schaltgerätes (100), wobei die wenigstens eine Schalteinrichtung (210, 221, 222, 310, 321, 322) durch die Steuereinheit (110) angesteuert wird,
- bei Absinken oder Ausbleiben der Versorgungsspannung, Versorgen der Steuereinheit (110) mit einer Energie, welche ausreicht, die wenigstens eine Schalteinrichtung (210, 221, 222, 310, 321, 322) derart anzusteuern, dass die Schalteinrichtung einen vorgegebenen Schaltvorgang ausführt, durch einen mit der Versorgungsspannung verbindbaren Energiespeicher (120), und
- Überwachen der Funktionsfähigkeit des Energiespeichers (120), wobei zu vorgegebenen Zeitpunkten, insbesondere zyklisch,
- der Energiespeicher (120) für eine vorgegebene Zeitdauer von der Versorgungseinrichtung getrennt wird, wobei die vorgegebene Zeitdauer so gewählt ist, dass während der vorgegebenen Zeitdauer im funktionsfähigen Zustand des Energiespeichers (120) die im Energiespeicher (120) gespeicherte Energie die zur Ausführung des vorgegebenen Schaltvorgangs erforderliche Energie nicht unterschreitet,
- eine dem Energiespeicher (120) zugeordnete Messgröße, welche ein Maß für die im Energiespeicher (120) gespeicherte Energie ist, gemessen wird,
- der Messwert mit einem vorgegebenen Schwellwert verglichen wird, und
- in Abhängigkeit des Vergleichsergebnisses die Funktionsfähigkeit des Energiespeichers (120) ermittelt wird.

9. Verfahren nach Anspruch 8, wobei bei Erkennen einer um ein vorgegebenes Maß reduzierten Funktionsfähigkeit des Energiespeichers (120) die wenigstens eine Schalteinrichtung (210, 221, 222, 310, 321, 322) derart angesteuert wird, dass die Schalteinrichtung den vorgegebenen Schaltvorgang ausführt, und/oder eine Fehlermeldung erzeugt wird.

10. Verfahren nach einem der Ansprüche 8 oder 9, wobei der vorgegebene Schaltvorgang eine Schaltsequenz zur sicheren Abschaltung einer über die wenigstens eine Schalteinrichtung (210, 221, 222, 310, 321, 322) geschalteten elektrischen Last (400) umfasst.

11. Verfahren nach einem der Ansprüche 8 bis 10, wobei das Schaltgerät (100) von weiteren Geräten, insbesondere weiteren Schaltgeräten, die an die Versorgungsspannung angeschlossen sind, derart entkoppelt wird, dass ein Abfließen von in dem Energiespeicher (120) gespeicherter Energie zu den weiteren Geräten verhindert wird.

12. Verfahren nach einem der Ansprüche 8 bis 11, wobei die Steuereinheit (110) die wenigstens eine Schalteinrichtung (210, 221, 222, 310, 321, 322) mit einem pulsweitenmodulierten Schaltsignal ansteuert, wobei der Aussteuergrad des pulsweitenmodulierten Schaltsignals von der Steuereinheit (110) in Abhängigkeit des Schaltzustands der Schalteinrichtung und/oder in Abhängigkeit der Versorgungsspannung und/oder in Abhängigkeit einer Umgebungstemperatur der Schalteinrichtung gesteuert wird.

13. Verfahren nach einem der Ansprüche 8 bis 12, wobei die Versorgungsspannung mittels einer mit der Steuereinheit (110) verbundenen Spannungsmesseinrichtung (112) überwacht wird.

## Claims

1. A switching apparatus (100) for controlling at least one switching device (210, 221, 222, 310, 321, 322), comprising
- a control unit (110) adapted to control the at least one switching device (210, 221, 222, 310, 321, 322);
- a connection (172, 174) for applying a supply voltage for power supply of the control unit (110);
- an energy storage (120) connectable to the connection (172, 174) for applying a supply voltage and adapted, when the supply voltage drops or fails, to supply sufficient power to the control unit (110) for controlling the at least one switching device (210, 221, 222, 310, 321, 322) such that the switching device (210, 221, 222, 310, 321, 322) executes a predetermined switching operation;
wherein the switching apparatus (100) comprises means (112, 114, 134, 140) for monitoring the operability of the energy storage (120),
**characterized in that**
the switching apparatus (100) comprises at least one measuring device (114) connected to the control unit (110), for measuring a parameter associated with the energy storage (120), which parameter is a measure of the energy stored in the energy storage (120), and means (140) for disconnecting the energy storage (120) from the supply voltage, which is controllable by the control unit (110); wherein
the control unit (110) is adapted to disconnect the energy storage (120) from the supply voltage at predetermined points in time for a predetermined period of time, to measure the parameter associated with the energy storage (120), and to compare the measured value with a predetermined threshold value; wherein the control unit (110) is further adapted to determine the operability of the energy storage (120) on the basis of the comparison result; and wherein
the energy storage (120) is dimensioned so that in the operational state of the energy storage (120), the energy stored in the energy storage (120) does not fall below the energy required to perform the predetermined switching operation during the predetermined period of time.

2. The switching apparatus according to claim 1, wherein the energy storage is implemented as a capacitor (120), the parameter associated with the energy storage is the voltage provided by the capacitor (120), and the measuring device for measuring the parameter associated with the energy storage is implemented as a voltage measuring device (114).

3. The switching apparatus according to any one of the preceding claims, which, when detecting that the operability of the energy storage (120) is reduced by a predetermined amount, is configured to control the at least one switching device (210, 221, 222, 310, 321, 322) such that the switching device executes the predetermined switching operation, and/or to generate an error message.

4. The switching apparatus according to any one of the preceding claims, wherein the predetermined switching operation comprises a switching sequence for safe switch-off of an electrical load (400) that is switched on and off via the at least one switching device (210, 221, 222, 310, 321, 322).

5. The switching apparatus according to any one of the preceding claims, comprising a decoupling device (132, 134) for decoupling the switching apparatus (100) from further apparatuses, in particular from further switching apparatus (100) which are connected to the supply voltage, wherein the decoupling device (132, 134) is adapted to prevent energy stored in the energy storage (120) from draining to the further apparatuses, and wherein the decoupling device in particular comprises at least one diode (132, 134).

6. The switching apparatus according to any one of the preceding claims, wherein the control unit (110) is adapted to control the at least one switching device (210, 221, 222, 310, 321, 322) using a pulse-width modulated switching signal, wherein the duty cycle of the pulse-width modulated switching signal is controlled by the control unit (110) as a function of the switching state of the switching device (210, 221, 222, 310, 321, 322), and/or as a function of the supply voltage, and/or as a function of an ambient temperature of the switching device (210, 221, 222, 310, 321, 322).

7. The switching apparatus according to any one of the preceding claims, comprising a voltage measuring device (112) connected to the control unit (110), for monitoring the supply voltage.

8. A method for controlling at least one switching device (210, 221, 222, 310, 321, 322) using a switching apparatus (100) according to any one of claims 1 to 7, comprising the steps of:
- applying a supply voltage to the switching apparatus (100) for power supply of a control unit (110) of the switching apparatus (100), wherein the at least one switching device (210, 221, 222, 310, 321, 322) is controlled by said control unit (110);
- if the supply voltage drops or fails, supplying sufficient power to the control unit (110) for controlling the at least one switching device (210, 221, 222, 310, 321, 322) such that the switching device executes a predetermined switching operation, using an energy storage (120) that is connectable to the supply voltage; and
- monitoring the operability of the energy storage (120); wherein at predetermined times, in particular cyclically,
- the energy storage (120) is disconnected from the power supply device for a predetermined period of time, wherein the predetermined period of time is selected such that in the operational state of the energy storage (120) the energy stored in the energy storage (120) does not fall below the energy required to execute the predetermined switching operation during said predetermined period of time;
- a parameter associated with the energy storage (120) is measured, which parameter is a measure of the energy stored in the energy storage (120);
- the measured value is compared with a predetermined threshold value; and
- the operability of the energy storage (120) is determined on the basis of the comparison result.

9. The method according to claim 8, wherein upon detection that the operability of the energy storage (120) is reduced by a predetermined amount, the at least one switching device (210, 221, 222, 310, 321, 322) is controlled such that the switching device executes the predetermined switching operation, and/or an error message is generated.

10. The method according to any one of claims 8 or 9, wherein the predetermined switching operation comprises a switching sequence for safe switch-off of an electrical load (400) that is switched on and off via the at least one switching device (210, 221, 222, 310, 321, 322).

11. The method according to any one of claims 8 to 10, wherein the switching apparatus (100) is decoupled from further apparatuses, in particular from further switching apparatuses connected to the supply voltage, so as to prevent energy stored in the energy storage (120) from draining to the further apparatuses.

12. The method according to any one of claims 8 to 11, wherein the control unit (110) controls the at least one switching device (210, 221, 222, 310, 321, 322) using a pulse-width modulated switching signal, wherein the duty cycle of the pulse-width modulated switching signal is controlled by the control unit (110) as a function of the switching state of the switching device and/or as a function of the supply voltage and/or as a function of an ambient temperature of the switching device.

13. The method according to any one of claims 8 to 12, wherein the supply voltage is monitored using a voltage measuring device (112) connected to the control unit (110).

## Revendications

1. Appareil de commutation (100) destiné à commander au moins un dispositif de commutation (210, 221, 222, 310, 321, 322), comprenant
- une unité de commande (110) qui est constituée pour commander l'au moins un dispositif de commutation (210, 221, 222, 310, 321, 322),
- une connexion (172, 174) destinée à appliquer une tension d'alimentation destinée à l'alimentation en énergie de l'unité de commande (110),
- un accumulateur d'énergie (120) pouvant être raccordé à la connexion (172, 174) pour appliquer une tension d'alimentation et qui est constitué pour, en cas de diminution ou d'absence de la tension d'alimentation, alimenter l'unité de commande (110) avec une énergie qui suffit pour commander l'au moins un dispositif de commutation (210, 221, 222, 310, 321, 322) de telle sorte que le dispositif de commutation (210, 221, 222, 310, 321, 322) exécute un processus de commutation prédéterminé,
où l'appareil de commutation (100) comporte des moyens (112, 114, 134, 140) destinés à surveiller la capacité de fonctionnement de l'accumulateur d'énergie (120), l'appareil de commutation (100) étant **caractérisé en ce qu'**il comporte au moins un dispositif de mesure (114), raccordé à l'unité de commande (100), destiné à mesurer une grandeur de mesure, affectée à l'accumulateur d'énergie (120), qui est une mesure de l'énergie accumulée dans l'accumulateur d'énergie (120), et un moyen (140), pouvant être commandé par l'unité de commande (110), destiné à séparer l'accumulateur d'énergie (120) de la tension d'alimentation,
où l'unité de commande (110) est constituée pour séparer de la tension d'alimentation l'accumulateur d'énergie (120) à des instants prédéterminés pendant une durée prédéterminée, pour mesurer la grandeur de mesure affectée à l'accumulateur d'énergie (120) et pour comparer la valeur de mesure à une valeur de seuil prédéterminée, où l'unité de commande (110) est en outre constituée pour déterminer la capacité de fonctionnement de l'accumulateur d'énergie (120) en fonction du résultat de la comparaison, et où l'accumulateur d'énergie (120) est dimensionné de telle sorte que, dans l'état fonctionnel de l'accumulateur d'énergie (120), l'énergie accumulée dans l'accumulateur d'énergie (120) ne passe pas au-dessous de l'énergie nécessaire pour l'exécution du processus de commutation prédéterminé pendant la durée prédéterminée.

2. Appareil de commutation selon la revendication 1, où l'accumulateur d'énergie est constitué en tant que condensateur (120), la grandeur de mesure affectée à l'accumulateur d'énergie est la tension fournie par le condensateur (120), et le dispositif de mesure est constitué en tant que dispositif de mesure de tension (114) destiné à mesurer la grandeur de mesure affectée à l'accumulateur d'énergie.

3. Appareil de commutation selon l'une des revendications précédentes, constitué pour, lors de la détection d'une quantité prédéterminée de réduction de la capacité de fonctionnement de l'accumulateur d'énergie (120), commander l'au moins un dispositif de commutation (210, 221, 222, 310, 321, 322) de telle sorte que le dispositif de commutation exécute le processus de commutation prédéterminé, et/ou pour produire un message d'erreur.

4. Appareil de commutation selon l'une des revendications précédentes, où le processus de commutation prédéterminé comprend une séquence de commutation destiné à mettre hors circuit de façon sûre une charge (400) électrique commutée par le biais de l'au moins un dispositif de commutation (210, 221, 222, 310, 321, 322).

5. Appareil de commutation selon l'une des revendications précédentes, comprenant un dispositif de découplage (132, 134) destiné à découpler l'appareil de commutation (100) d'autres appareils, en particulier d'autres appareils de commutation (100), qui sont connectés à la tension d'alimentation, où le dispositif de découplage (132, 134) est constitué pour empêcher un écoulement de l'énergie accumulée dans l'accumulateur d'énergie (120) vers les autres appareils, et où le dispositif de découplage comprend en particulier au moins une diode (132, 134) .

6. Appareil de commutation selon l'une des revendications précédentes, où l'unité de commande (110) est constituée pour commander l'au moins un dispositif de commutation (210, 221, 222, 310, 321, 322) avec un signal de commutation à modulation de largeur d'impulsion, où le degré de modulation du signal de commutation à modulation de largeur d'impulsion est commandé par l'unité de commande (110) en fonction de l'état de commutation du dispositif de commutation (210, 221, 222, 310, 321, 322) et/ou en fonction de la tension d'alimentation et/ou en fonction d'une température ambiante du dispositif de commutation (210, 221, 222, 310, 321, 322).

7. Appareil de commutation selon l'une des revendications précédentes, comprenant un dispositif de mesure de tension (112) raccordé à l'unité de commande (110) et destiné à surveiller la tension d'alimentation.

8. Procédé destiné à commander au moins un dispositif de commutation (210, 221, 222, 310, 321, 322) au moyen d'un appareil de commutation (100) selon l'une des revendications 1 à 7, avec les étapes consistant à :
- appliquer une tension d'alimentation à l'appareil de commutation (100) pour l'alimentation en énergie d'une unité de commande (110) de l'appareil de commutation (100), où l'au moins un dispositif de commutation (210, 221, 222, 310, 321, 322) est commandé par l'unité de commande (110),
- en cas de diminution ou d'absence de la tension d'alimentation, alimenter, par un accumulateur d'énergie (120) pouvant être raccordé à la tension d'alimentation, l'unité de commande (110) avec une énergie qui suffit pour commander l'au moins un dispositif de commutation (210, 221, 222, 310, 321, 322) de telle sorte que le dispositif de commutation exécute un processus de commutation prédéterminé, et
- surveiller la capacité de fonctionnement de l'accumulateur d'énergie (120), où à des instants prédéterminés, en particulier de façon cyclique,
- l'accumulateur d'énergie (120) est séparé du dispositif d'alimentation pendant une durée prédéterminée, où la durée prédéterminée est choisie de telle sorte que, pendant la durée prédéterminée, dans l'état fonctionnel de l'accumulateur d'énergie (120), l'énergie accumulée dans l'accumulateur d'énergie (120) ne passe pas au-dessous de l'énergie nécessaire pour l'exécution du processus de commutation prédéterminé,
- une grandeur de mesure affectée à l'accumulateur d'énergie (120), laquelle est une mesure de l'énergie accumulée dans l'accumulateur d'énergie (120), est mesurée,
- la valeur de mesure est comparée à une valeur de seuil prédéterminée, et
- en fonction du résultat de la comparaison, la capacité de fonctionnement de l'accumulateur d'énergie (120) est déterminée.

9. Procédé selon la revendication 8, où l'au moins un dispositif de commutation (210, 221, 222, 310, 321, 322) est, lors de la détection d'une quantité prédéterminée de réduction de la capacité de fonctionnement de l'accumulateur d'énergie (120), commandé de telle sorte que le dispositif de commutation exécute le processus de commutation prédéterminé, et/ou un message d'erreur est produit.

10. Procédé selon l'une des revendications 8 ou 9, où le processus de commutation prédéterminé comprend une séquence de commutation destinée à mettre hors circuit de façon sûre une charge (400) électrique commutée par le biais de l'au moins un dispositif de commutation (210, 221, 222, 310, 321, 322).

11. Procédé selon l'une des revendications 8 à 10, où l'appareil de commutation (100) est découplé d'autres appareils, en particulier d'autres appareils de commutation qui sont connectés à la tension d'alimentation, de telle sorte qu'un écoulement de l'énergie accumulée dans l'accumulateur d'énergie (120) vers les autres appareils est empêché.

12. Procédé selon l'une des revendications 8 à 11, où l'unité de commande (110) commande l'au moins un dispositif de commutation (210, 221, 222, 310, 321, 322) avec un signal de commutation à modulation de largeur d'impulsion, où le degré de modulation du signal de commutation à modulation de largeur d'impulsion est commandé par l'unité de commande (110) en fonction de l'état de commutation du dispositif de commutation et/ou en fonction de la tension d'alimentation et/ou en fonction d'une température ambiante du dispositif de commutation.

13. Procédé selon l'une des revendications 8 à 12, où la tension d'alimentation est surveillée au moyen d'un dispositif de mesure de tension (112) raccordé à l'unité de commande (110).
